# EUROPEAN PATENT APPLICATION

(11) **EP 4 845 322 A1**
(43) Date of publication of application: **25.11.2026**
(21) Application number: 25867310.2
(22) Date of filing: 09.09.2025
(51) Int. Cl.: H05K 7/20

(54) **LIQUID COOLING SYSTEM FOR ELECTRONIC DEVICE, ELECTRONIC DEVICE, AND LIQUID COOLING CONTROL METHOD FOR ELECTRONIC DEVICE**

(30) Priority: 31.03.2025 CN 202510396365
(71) Applicant: Suzhou Metabrain Intelligent Technology Co., Ltd., Suzhou, Jiangsu 215000 (CN)
(72) Inventor: ZHU, Huanlai, Suzhou Jiangsu 215000 (CN); CAI, Wei, Suzhou Jiangsu 215000 (CN); LIU, Guangzhi, Suzhou Jiangsu 215000 (CN); WU, An, Suzhou Jiangsu 215000 (CN); WANG, Yuxi, Suzhou Jiangsu 215000 (CN); LI, Xiaomao, Suzhou Jiangsu 215000 (CN)
(74) Representative: Studio Torta S.p.A.
(86) International application number: PCT/CN2025/120151
(87) International publication number: WO 2026/208088

(57) **Abstract**

Disclosed are a liquid cooling system for an electronic device, an electronic device, and liquid cooling control method for an electronic device, relating to the technical field of heat dissipation of electronic devices. The liquid cooling system for an electronic device includes a condensing device; a liquid cooling pipeline, wherein the liquid cooling pipeline is in communication with the condensing device; a cooling medium in the liquid cooling pipeline sequentially passes through first components, third components and second components of an electronic device, and returns to the condensing device; the heat-generating power dissipation of the third components is greater than that of the first components or the second components; and the cooling medium experiences a gas-liquid state change when passing through at least one component of the first components, the second components and the third components. By fully utilizing the absorption potential of each phase during the gas-liquid two-phase state change of the cooling medium in the liquid cooling pipeline, and combining with the heat dissipation characteristics of each component, the highest heat dissipation effect is achieved, thereby solving the problem of poor cooling effect of the two-phase liquid cooling system in the related art, and achieving the objective of greatly improving the cooling effect of the two-phase liquid cooling system.

## Description

### Cross-Reference to Related Application

The invention claims priority to Chinese Patent Application no. 202510396365.9, to the China National Intellectual Property Administration on March 31, 2025 and entitled "Liquid Cooling System for Electronic Device, Electronic Device, and Liquid Cooling Control Method for Electronic Device", which is incorporated herein by reference in its entirety.

### Technical Field

The invention relates to the technical field of heat dissipation of an electronic device, and in particular, to a liquid cooling system for an electronic device, an electronic device, and a liquid cooling control method for an electronic device.

### Background

Currently, in liquid cooling systems of electronic devices such as servers, two-phase cold plates are widely used due to their inherent advantages in solving high heat density and high power dissipation. In a two-phase liquid cooling system, the heat exchange efficiency of boiling is much higher than that of single-phase convective heat exchange. However, in current two-phase liquid cooling systems, the vaporization of the coolant may not be stably controlled. If the coolant does not fully vaporize in the heat source, meaning that the dryness is too low, most of the coolant will flow through the heat source in a liquid state, significantly reducing the heat exchange efficiency. On the other hand, if the coolant completely vaporizes in all heat sources, meaning that the dryness is too high, further overheating of the coolant will not effectively absorb the heat from the source, which also reduces cooling efficiency, thereby resulting in a poor cooling effect of the two-phase liquid cooling system as a whole.

### Summary

Some embodiments of the invention provide a liquid cooling system for an electronic device, an electronic device, and a liquid cooling control method for an electronic device, so as to at least solve the problem in the related art of a poor cooling effect of a two-phase liquid cooling system.

In an embodiment of the invention, a liquid cooling system for an electronic device is provided, including: a condensing device; a liquid cooling pipeline, wherein the liquid cooling pipeline is in communication with the condensing device; a cooling medium in the liquid cooling pipeline sequentially passes through first components, third components and second components of an electronic device, and returns to the condensing device; the heat-generating power dissipation of the third components is greater than that of the first components or the second components; and the cooling medium undergoes a gas-liquid phase change when passing through at least one component of the first components and the second components.

In another embodiment of the invention, an electronic device is provided, including: a cabinet; at least one electronic node, wherein the at least one electronic node are provided in the cabinet, and each of the at least one electronic node includes first components, second components and third components; and the liquid cooling system for an electronic device, wherein a liquid cooling pipeline penetrates between the cabinet and the at least one electronic node.

In yet another embodiment of the invention, a liquid cooling control method for an electronic device is also provided, which is executed using the described electronic device, wherein the liquid cooling control method for an electronic device includes: acquiring a node power dissipation of each component in the electronic device and a node flow rate in a liquid cooling pipeline where the component is located; comparing a relationship between the node power dissipation and the node flow rate with a preset condition; and if the relationship does not satisfy the preset condition, controlling and adjusting an opening degree of a valve on the electronic device until the relationship between the node power dissipation and the node flow rate satisfies the preset condition; acquiring a total power dissipation of the electronic device and a total flow rate in the liquid cooling pipeline; comparing a relationship between the total power dissipation and the total flow rate with the preset condition; and if the relationship does not satisfy the preset condition, controlling and adjusting an opening degree of a control valve at an inlet of the liquid cooling pipeline until the relationship between the total power dissipation and the total flow rate satisfies the preset condition.

By means of the embodiments of the invention, an optimal design is performed on the fitting relationship between the first components, the second components and the third components and the liquid cooling pipeline, and the liquid cooling pipeline passes through the first components, the third components, and the second components in sequence, so that by fully utilizing the absorption potential of each phase during the gas-liquid two-phase state change of the cooling medium in the liquid cooling pipeline, and combining with the heat dissipation characteristics of each component, the highest heat dissipation effect is achieved, thereby solving the problem of poor cooling effect of the two-phase liquid cooling system in the related art, and achieving the objective of greatly improving the cooling effect of the two-phase liquid cooling system.

### Brief Description of the Drawings

To describe the embodiments of invention more clearly, the following briefly describes the accompanying drawings required for describing the embodiments. Apparently, the accompanying drawings in the following description show merely some embodiments of the invention, and a person of ordinary skill in the art may still derive other embodiments from these accompanying drawings without creative efforts.
Fig. 1 is a structural block diagram of a liquid cooling system for an electronic device according to an embodiment of the invention;
Fig. 2 is a front view of an electronic device according to an embodiment of the invention;
Fig. 3 is a side view of an electronic device according to an embodiment of the invention;
Fig. 4 is a schematic structural diagram of a liquid cooling pipeline on a back panel of an electronic device according to an embodiment of the invention;
Fig. 5 is a schematic structural diagram of a liquid cooling pipeline of a graphic node of an electronic device according to an embodiment of the invention;
Fig. 6 is a schematic structural diagram of a liquid cooling pipeline of a computing node of an electronic device according to an embodiment of the invention;
Fig. 7 is a schematic structural diagram of an entire liquid cooling pipeline of an electronic device according to an embodiment of the invention;
Fig. 8 is a flowchart of a liquid cooling control method for an electronic device according to an embodiment of the invention.

The drawings include the following reference signs:
10. condensing device; 20. liquid cooling pipeline; 21. first segment; 211. common segment; 212. branch segment; 22. second segment; 23. third segment; 30. control valve; 40. flow meter; 50. valve; 60. acquisition device; 70. control device; 80. cabinet; 81. back panel; 90. an electronic node; 91. first component; 92. second component; 93. third component; 100. manifold; 110. first cooling device.

### Detailed Description of the Embodiments

Hereinafter, the technical solutions in the embodiments of the invention will be described clearly and thoroughly with reference to the accompanying drawings of the embodiments of the invention. Obviously, the embodiments as described are only some of the embodiments of the invention, and are not all of the embodiments of the invention. All other embodiments obtained by a person skilled in the art on the basis of the embodiments in the application without creative work shall fall within the scope of protection of the invention.

It should be noted that orientations or position relationships indicated by terms such as "center", "longitudinal", "lateral", "length", "width", "thickness", "on", "under", "front", "back", "left", "right", "vertical", "horizontal", "top", "bottom", "in", "out", "clockwise", "anticlockwise", "axial", "radial", "circumferential", and the like are orientations or position relationships based on accompanying drawings and are only for the convenience of illustration of the specification and simplicity of illustration, rather than explicitly or implicitly indicate that apparatuses or components referred to herein must have a certain direction or be configured or operated in a certain direction and therefore may not be understood as limitations to the invention. The terms such as "mount", "connected" and "connection" should be understood in a broad sense, for example, the connection may be a fixed connection, or a detachable connection, or an integral connection; may be mechanical connection, and may also be electrical connection; and may be direct connection, and may also be indirect connection by means of an intermediate medium, and may also be interior communication between two elements. The terms "parallel," "perpendicular," and "equal" include the stated situation and situations approximately similar thereto, with the scope of such similar situations falling within an acceptable deviation range, wherein the acceptable deviation range is determined by a person skilled in the art by considering the measurements being discussed and the errors associated with the measurement of specific quantities, as determined by a person skilled in the art (i.e. the limitations of the measurement system). For example, "parallel" includes both absolutely parallel and approximately parallel, wherein the acceptable deviation range for approximately parallel may, for example, be a deviation of up to 5°; "vertical" includes both absolutely vertical and approximately vertical, wherein the acceptable deviation range for approximately vertical may also be a deviation of up to 5°; and "Equal" includes both absolutely vertical and approximately vertical, wherein the acceptable deviation range for approximately vertical may, for example, be that the difference between the two equal entities is less than or equal to 5% of either of them. For those of ordinary skill in the art, the specific meanings of the above terms in the invention may be understood according to specific situations.

To make a person skilled in the art better understand the solutions of the invention, the invention is further described in detail with reference to the accompanying drawings and specific embodiments.

In order to solve the problem in the related art of a poor cooling effect of a two-phase liquid cooling system, the invention provides a liquid cooling system for an electronic device, an electronic device, and a liquid cooling control method for the electronic device.

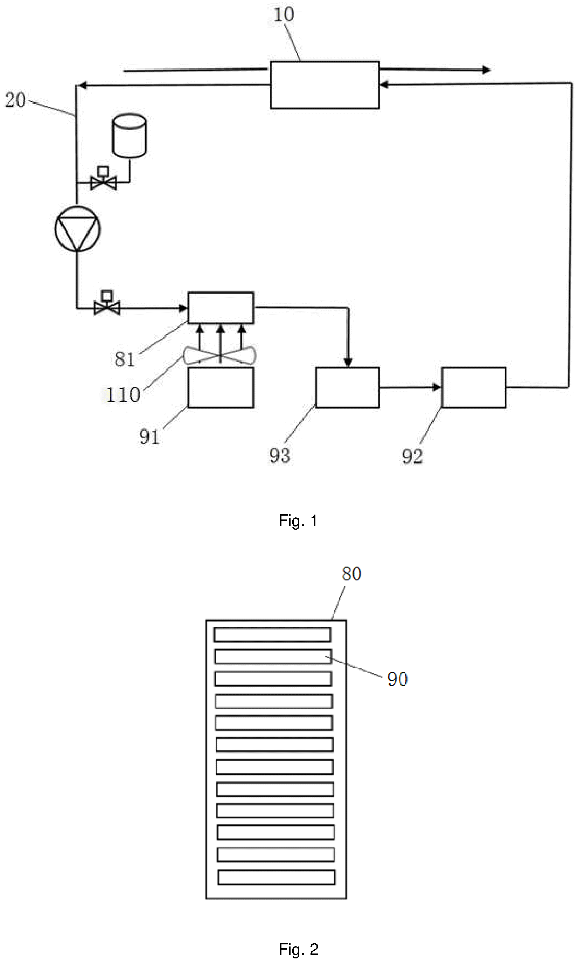

A liquid cooling system for an electronic device, as shown in Fig. 1, includes a condensing device 10 and a liquid cooling pipeline 20, wherein the liquid cooling pipeline 20 is in communication with the condensing device 10; a cooling medium in the liquid cooling pipeline 20 sequentially passes through first components 91, third components 93 and second components 92 of an electronic device, and returns to the condensing device 10; the heat-generating power dissipation of the third components 93 is greater than that of the first components 91 or the second components 92; and the cooling medium experiences a gas-liquid state change when passing through at least one component.

In the present embodiment, an optimal design is performed on the fitting relationship between the first components 91, the second components 92 and the third components 93 and the liquid cooling pipeline 20, and the liquid cooling pipeline 20 passes through the first components 91, the third components 93, and the second components 92 in sequence, so that by fully utilizing the absorption potential of each phase during the gas-liquid two-phase state change of the cooling medium in the liquid cooling pipeline 20, and combining with the heat dissipation characteristics of each component, the highest heat dissipation effect is achieved, thereby solving the problem of poor cooling effect of the two-phase liquid cooling system in the related art, and achieving the objective of greatly improving the cooling effect of the two-phase liquid cooling system.

In the present embodiment, the heat dissipation power dissipation of the first components 91, the second components 92, and the third components 93 increases in sequence from low to high, such that when the liquid cooling pipeline 20 passes through these three components, the power dissipation arrangement order is in a "low-medium-high" pattern. This may further improve the cooling effect, ensuring that all three components are well cooled. Certainly, in addition to the foregoing arrangement manners, other arrangement manners may also be adopted.

For example, in an unillustrated embodiment, the power dissipation of the first components 91, the second components 92, and the third components 93 is such that the power dissipation of the first components 91 is the highest, while the power dissipation of the second components 92 and the third components 93 is relatively low, so that the power dissipation arrangement sequence in which the liquid cooling pipeline 20 passes through the foregoing three components is in the form of "high-low-low". Certainly, there are more other arrangements.

It should be noted that the number of components may not be limited to three, and thus the arrangement of the aforementioned components may represent only the arrangement of some components through which the liquid cooling circuit 20 passes; for example, other components may be added in the "low-high-medium" arrangement in the present embodiment; the components may also include fourth components, and the arrangement of components through which the liquid cooling circuit 20 passes would then be as follows: first components 91, fourth components, third components 93, and second components 92. That is to say, as long as any three components through which the liquid cooling pipeline 20 passes satisfy the required power dissipation arrangement requirement, the liquid cooling pipeline 20 may pass through more components, and the arrangement manner of these components may be set as required.

The cooling medium in the present embodiment has a subcooled liquid state, a saturated liquid state, a saturated vapor state, and an overheated vapor state. The subcooled liquid state refers to the cooling medium being in a completely liquid state, having capacity to absorb heat before transitioning into a gaseous state. The saturated liquid state refers to the cooling medium being in a liquid state, while simultaneously in a critical state between liquid and gaseous states; in this case, any additional heat absorption will cause the cooling medium to transition into the vapor state. The saturated vapor state refers to the cooling medium being in a gaseous state, and being in a critical state where it has completely transitioned from liquid to gas. The superheated vapor refers to the state formed when the cooling medium continues to absorb heat on the basis of the saturated vapor medium.

Based on the above states of the cooling medium, when the liquid cooling medium passes through the first components 91, the third components 93, the second elements 92, and the condensing device 10, the phase change is as follows: the cooling liquid medium in the condensing device 10 is in a subcooled state; the subcooled liquid medium absorbs heat at the first components 91 to form a saturated liquid medium, then absorbs heat at the third components 93 to form a saturated vapor medium, then absorbs heat at the second components 92 to form superheated vapor, and then is condensed in the condensing device 10 to form a subcooled liquid medium. The described process fully utilizes the subcooled single-phase (liquid-phase) in the subcooling segment of the two-phase coolant to absorb heat from components with low power dissipation, utilizes the two-phase latent heat of vaporization with the highest heat exchange efficiency to absorb heat from components with high power dissipation, and utilizes the superheat of the single-phase (superheated vapor) to absorb heat from components with medium power dissipation. In this way, the absorption potential of each phase is fully utilized, and in combination with the heat dissipation characteristics of each component, the most effective cooling effect is achieved.

It should be noted that the phase state change of the cooling medium described above is not strict and may have fluctuations. For example, after absorbing heat at the first components 91, the subcooled liquid medium may also form a phase state close to the saturated liquid state or form a slightly supersaturated liquid state. However, this would affect the subsequent heat absorption effect, resulting in a slight decrease in the overall cooling effect, but it may still improve the cooling effect compared to conventional methods.

The liquid cooling system for an electronic device in the present embodiment may be provided in a rack-scale server, may also be provided in a single-node server. Meanwhile, it is not limited to servers, and the liquid cooling system may also be provided in other devices such as switches and routers.

When being provided in a single-node device such as a single node server, the first components 91, the second components 92 and the third components 93 are located in the same electronic node 90. In this case, the liquid cooling pipeline 20 includes a first segment 21, third segments 23 and second segments 22 that are in heat exchange cooperation with the first components 91, the third components 93 and the second components 92 respectively, wherein the first segment 21, the second segments 22, and the third segments 23 are located at the same electronic node 90 of the electronic device, so that the first segment 21, the second segments 22, and the third segments 23 may cooperate with the first components 91, the second components 92 and the third components 93, to achieve heat exchange of the cooling medium, thereby achieving cooling and heat dissipation of the electronic device.
When being provided in a rack-scale server, the rack-scale server is provided with a plurality of electronic nodes 90, and different components are respectively provided in the plurality of electronic nodes 90. In this case, the liquid cooling pipeline 20 still includes a first segment 21, third segments 23 and second segments 22 that are in heat exchange cooperation with the first components 91, the third components 93 and the second components 92 respectively, however, different from the setting of the single-node server, at least one of the first segment 21, the second segments 22, and the third segments 23 is located at a different electronic node 90 of the electronic device, and may cooperate with components in different electronic nodes 90, thereby implementing heat exchange with the components and further implementing heat dissipation.

In the present embodiment, the subsequent explanation will primarily use a rack-scale server as an example. However, the later design may also be applied to a single-node server.

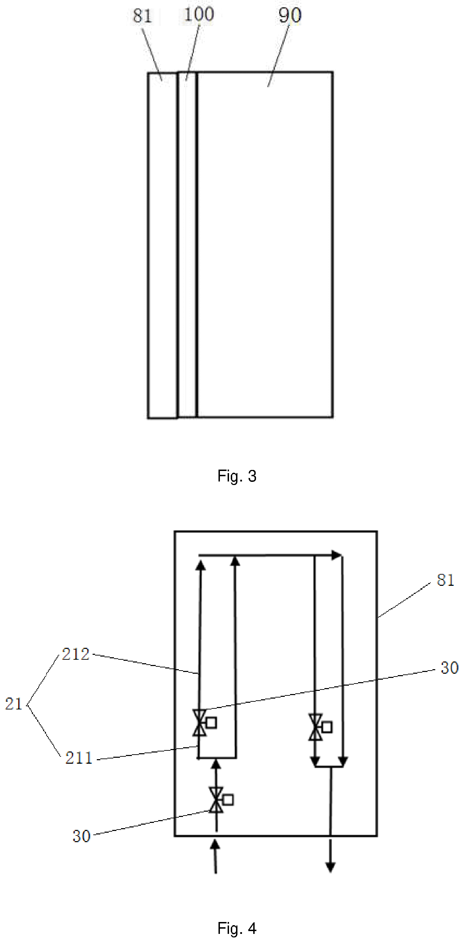

As shown in Fig. 4, in the present embodiment, the first segment 21 includes a common segment 211 and a plurality of branch segments 212; the plurality of branch segments 212 are connected and in communication with the common segment 211; and the plurality of branch segments 212 are located in a heat dissipation region of the first components 91. In this way, on the one hand, the plurality of branch segments 212 may cooperate with the plurality of first components 91, so as to achieve a unified heat dissipation effect; on the other hand, the structural form of the serial-to-parallel pipeline may implement control over a single branch segment 212 and control over the entire first segment 21, thereby providing a structural foundation for subsequent flow control.

In the present embodiment, the liquid cooling system for an electronic device further includes a control valve 30 configured to control a flow, wherein the control valve 30 is provided on the common segment 211 and/or at least one of the plurality of branch segments 212. In the present embodiment, a control valve 30 is provided on both the common segment 211 and the plurality of branch segments 212, and the flow rates of the common segment 211 and the plurality of branch segments 212 may be controlled by means of the control valve 30. The control valve 30 is mainly provided to solve the problem of flow distribution/drift of electronic nodes 90 in the parallel rack-scale servers. Due to the issue of flow drift between different rack-scale servers, the flow distribution between the rack-scale servers may be dynamically adjusted by means of the control valve 30 on the common segment 211. The control valve 30 on the branch segment 212 is configured to control the heat exchange of the back panel 81 on which the first segment 21 is located. In winter, the open degree of the control valve 30 may be reduced or even closed to reduce the heat exchange of the back panel 81, thereby preventing the temperature inside the machine room from being too low. In summer, the control valve 30 may be fully opened to increase the heat exchange of the back panel 81, thereby preventing the temperature inside the machine room from being too high.

It should be noted that, the foregoing settings of the first segment 21 are not only applicable to a rack-scale server, but also applicable to a single-node server.

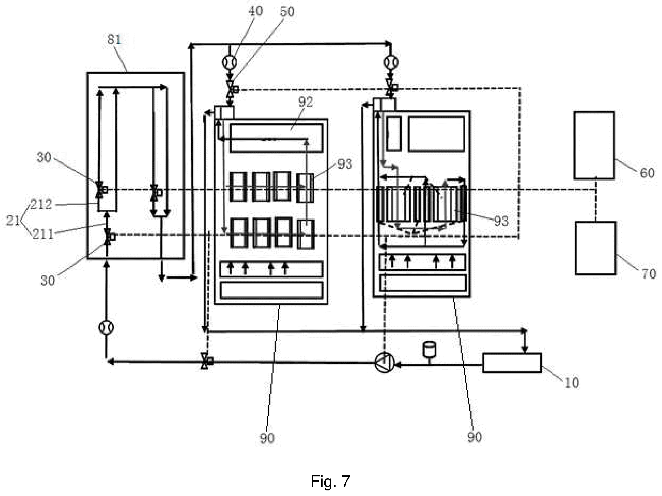

As shown in Fig. 7, when there are a plurality of electronic nodes 90 of the rack-scale server, in the present embodiment, there are a plurality of third components 93 which are grouped into a plurality of groups; the third components 93 in different groups are arranged in layers and are arranged in the same or different electronic nodes 90; in the present embodiment, the third components 93 are grouped according to types, so that the plurality of electronic nodes 90 are classified into computing nodes including central processing modules and graphic nodes including graphic processing modules, wherein the computing nodes and the graphic nodes are respectively located on different layers of the cabinet 80. Based on this, in the present embodiment, there are a plurality of third segments 23 which are connected and in communication with the first segment 21; and the third segments 23 are located at different groups of the third components 93, since the third segments 23 cooperate with the computing nodes and graphics nodes, the cooling medium in the first segment 21 may be distributed to the third segments 23, so as to enter different electronic nodes 90 to be in heat exchange cooperation with the components within these nodes, achieving heat exchange of the rack-scale server.
Accordingly, in addition to the plurality of third components 93, there are also a plurality of second components 92 of the rack-scale server, and the second components 92 are provided at layers where the third components 93 of different groups are located, so that the third components 93 and the second components 92 are provided in all electronic nodes 90. Accordingly, there are also a plurality of second segments 22, and the second segments 22 are located at the second components 92 of different layers, and are connected and in communication with the third segments 23 of the same layer, so that the second segments 22 are provided in all the electronic nodes 90, thus, the cooling medium of the first segment 21 is distributed to the third segments 23 of the electronic nodes 90, and then enters the second segments 22 of the electronic nodes 90 by means of the third segments 23, and then converge from the second segments 22 and enter the condensing device 10 together, so as to implement cooling and heat dissipation of all the at least one electronic node 90 in the rack-scale server.
Certainly, the arrangement manner of the third components 93 and the second components 92 may also be adjusted as required, different groups of the third components 93 and the second components 92 may also be provided in the same electronic node 90, and the third components 93 may also be grouped according to other factors, which is not limited to grouping according to types in the present embodiment. Furthermore, the number of the third components 93 and the number of the second components 92 in the same electronic node 90 may also be set as required, one or more may be provided, so that the electronic nodes 90 may have multiple functions. In this case, the third segments 23 and the second segments 22 in the electronic nodes 90 may be further designed as required, such as adding a parallel structure, so that all components requiring heat dissipation in the electronic nodes 90 may cooperate with corresponding segments, achieving comprehensive heat dissipation.

In the present embodiment, the liquid cooling system for an electronic device further includes a flow meter 40 and a valve 50, wherein the flow meter 40 and the valve 50 are provided at an inlet end of the second segment 22. The flow meter 40 and the valve 50 may control the flow rate of the cooling medium entering each of the plurality of electronic nodes 90, and may cooperate with the described control valve 30 to dynamically adjust the flow rate of the cooling medium in each of the plurality of electronic nodes 90 of the rack-scale server, achieving the effect of adapting the flow rate to the power dissipation, and further improving the cooling effect.

The liquid cooling system for an electronic device in the present embodiment further includes an acquisition device 60 and a control device 70, wherein the acquisition device 60 is electrically connected to the flow meter 40, the acquisition device 60 may acquire the flow data in the flow meter 40 and the power dissipation condition of each component; the control device 70 is electrically connected to components such as the acquisition device 60, the valve 50 and the control valve 30; the control device 70 may receive and process the flow data and the power dissipation condition which are acquired by the acquisition device 60, thereby controlling the opening degrees of the control valve 30 and the valve 50 according to the flow data and power dissipation condition, so as to associate the power dissipation with the flow, dynamically adjust the cooling condition of each component, increase the flow rates of the components or electronic nodes 90 with improved power dissipation, decrease the flow rates of the components or electronic nodes 90 with decreased power dissipation, thereby solving a problem of flow drift. In the present embodiment, by designing the cooperation between the liquid cooling pipeline 20 and components with different power dissipation, along with the dynamic adjustment between flow rate and the power dissipation, the components cooperate with each other as a whole, so that the electronic device may stably and reliably perform cooling and heat dissipation.

It should be noted that the dynamic adjustment design of the control valve 30, the flow meter 40, and the valve 50 is not only applicable to a rack-scale server, but also applicable to a single-node server; when they are provided in the rack-scale server, the power dissipation and flow rates of the electronic nodes 90 are primarily adjusted and allocated; while when they are provided in the single-node server, the power dissipation and flow rates of the components are primarily adjusted and allocated.

The liquid cooling system for an electronic device in the present embodiment further includes a circulating pump. The circulating pump is provided on the liquid cooling pipeline 20, and in the present embodiment, the circulating pump is provided at an outlet of the condensing device 10, so as to provide power for the flow of the cooling medium. In the present embodiment, the absorption potential of the cooling medium is fully utilized, so that the power dissipation of the circulating pump may be used as much as possible, thereby not only completely eliminating the cavitation risk of the circulating pump faced by the server, but also significantly reducing the power dissipation of the circulating pump. Meanwhile, since the subcooling degree of the inlet of the circulating pump meets requirements, the service life and reliability of the circulating pump are prolonged.

As shown in Fig. 2 to Fig. 7, the present embodiment further provides an electronic device, including a cabinet 80, at least one electronic node 90, and the liquid cooling system for an electronic device, wherein the plurality of electronic nodes 90 are provided in the cabinet 80; each of the plurality of electronic nodes 90 includes first components 91, second components 92, and third components 93; there may be one or more electronic nodes 90; when there is one electronic node 90, the electronic device is a single-node server; and when there are a plurality of electronic nodes 90, the electronic device is a rack-scale server. The liquid cooling pipeline 20 penetrates between the cabinet 80 and the electronic node 90. For the arrangement manner of the liquid cooling pipeline 20, reference is made to the foregoing description of the liquid cooling system for an electronic device, and details are not repeatedly described herein. The electronic device formed by the described liquid cooling system for an electronic device may not only fundamentally solve the leakage risk of the current mainstream single-phase liquid cooling servers in the entire cabinet and the inadequacy in facing components with high heat density, but also completely eliminate the cavitation risk of the circulating pump faced by the two-phase liquid cooling servers in the cabinet, save 60% of the power dissipation of the circulating pump, improve the heat dissipation efficiency of the condenser end by 50%, reduce the volume and cost of the condensation heat exchanger of the condensing device by 50%, and also solve the problem of flow drift of parallel liquid cooling servers in the entire cabinet.

The electronic nodes 90 described in the present embodiment include, but is not limited to, at least one of a computing node, a switching node, and a storage node.

When there is one electronic node 90, that is, the electronic device is a single-node device, for example, a single node server, a switch, and a router, the first component components 91, the second components 92, and the third components 93 are all provided in the electronic node 90. In this case, the liquid cooling pipeline 20 penetrates through the electronic node 90, and in heat exchange cooperation with the first components 91, the third components 93, and the second components 92 in sequence, thereby achieving a cooling and heat dissipation effect. In this case, the series-parallel structure form of the liquid cooling pipeline 20 may be set according to components requiring heat dissipation. For example, if there are three third components 93, the third segments 23 may be divided into three parallel branches, and the three parallel branches are respectively in heat exchange cooperation with the three third components 93.

When there are a plurality of electronic nodes 90, that is, the electronic device is an entire device, for example, a rack-scale server, as shown in Fig. 2, the plurality of electronic nodes 90 may be arranged in layers in the cabinet 80 from top to bottom. In this case, the first segment 21 of the liquid cooling pipeline 20 may penetrate throughout between the plurality of electronic nodes 90 as a whole and pass through the heat dissipation regions of the first components 91 of the plurality of electronic nodes 90, so as to perform heat exchange cooperation with the first components 91 of the plurality of electronic nodes 90 respectively. The second segments 22 and the third segments 23 respectively penetrate throughout inside the plurality of electronic nodes 90, so that the second segments 22 and the third segments 23 of the liquid cooling pipeline 20 are provided in each of the plurality of electronic nodes 90. The second segments 22 and the third segments 23 may perform heat exchange cooperation with the second components 92 and the third components 93 in the respective electronic nodes 90.

In some embodiments, each of the first components 91 includes at least one of an input/output module and a hard disk module; each of the second components 92 includes at least one of a power supply module and a storage module; and each of the third components 93 includes at least one of a graphics processing module and a central processing module. Certainly, the first components 91, the second components 92, and the third components 93 are not limited to the foregoing examples in the present embodiment, and may also be increased or decreased as required, and more components such as fourth components and fifth components may also be added as required.

As shown in Figs. 3 and 7, the electronic device of the present embodiment further includes a manifold 100. The manifold 100 is configured to distribute and converge the flow between the first segment 21 of the rack-scale server and the third segments 23 in each of the plurality of electronic nodes 90, and between the second segments 22 in each of the plurality of electronic nodes 90 and the condensing device 10. Accordingly, the manifold 100 is mainly provided on a rack-scale server, and for a single-node server, the manifold 100 may be provided as required, and the manifold 100 may not be provided. In a scenario based on a rack-scale server, in the present embodiment, a manifold 100 is provided between the first segment 21 and the third segments 23, and between the second segments 22 and the condensing device 10; in some embodiments, the manifold 100 is provided at an inner side of the back panel 81 of the cabinet 80, such that the cooling medium of the first segment 21 is distributed to the third segments 23 of each electrical node 90 by means of the manifold 100; and after passing through the third segments 23 and the second segments 22, the cooling medium of the second segments 22 is converged again to the condensing device 10 by means of the manifold 100.

The manifolds 100 may be provided in multiple units, respectively serving the functions of distributing flow to the third segments 23 and converging flow to the condensing device 10; alternatively, a single manifold 100 may be provided, wherein the single manifold 100 has two independent structural functions of flow distribution and flow converging, thereby achieving both distribution and converging effects.

In some embodiments, the electronic device includes a first cooling apparatus 110; the first cooling apparatus 110 is provided at the first component 91; the first cooling apparatus 110 has a heat dissipation region; and the first segment 21 of the liquid cooling pipeline 20 absorbs heat of the first components 91 by means of the heat dissipation region. Considering that the first components 91 are components with low power dissipation, the first components 91 may be cooled by means of a first cooling device 110. In some embodiments, the first cooling device 110 is in the form of an air cooling device, and the air cooling device is connected to the first components 91, thereby implementing air cooling and heat dissipation of the first components 91. In this case, the air outlet of the air cooling device serves as a heat dissipation region, and the branch segment 212 of the first segment 21 passes through the heat dissipation region, so as to exchange heat with hot air in the heat dissipation region, thereby achieving a cooling effect on the first components 91. The air cooling device drives cold air to pass through the first components 91 to form hot air, and the hot air undergoes heat exchange with the first segment 21 to become cold air and is blown out from the cabinet 80.

As shown in Fig. 4, the cabinet 80 in the present embodiment includes a back panel 81. The air cooling device is provided at the back panel 81, may be embedded in the back panel 81, and also may be provided on the inner side of the back panel 81. The back panel 81 is provided with ventilation holes, and the heat dissipation region of the air cooling device faces the ventilation holes of the back panel 81. In this way, the air cooling device discharges the hot air from the ventilation holes to the machine room, and the first segment 21 of the liquid cooling pipeline 20 penetrates through the back panel 81. The first segment 21 of the present embodiment is divided into four sections: an inlet section, an outlet section, two parallel sections, and a transition section. The inlet section and the outlet section serve as the common segment 211, and the parallel sections serve as the plurality of branch segments 212, all of which extend longitudinally. The inlet section and the outlet section are both located below the parallel sections, and the two parallel sections are arranged laterally spaced apart. The transition section is provided at the tops of the two parallel sections, and the transition section is simultaneously connected and in communication with the two parallel sections, so that the flow path of the first segment 21 is: the inlet section, one parallel section, the transition section, the other parallel section, and the outlet section. After being distributed by the manifold 100, the cooling medium flowing out from the outlet section passes through the flow meter 40 and the valve 50 again, and then enters the third segments 23 of each of the plurality of electronic nodes 90.

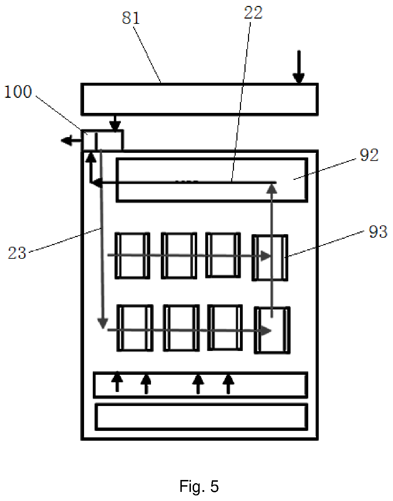

As shown in Fig. 5, the graphic node is internally provided with graphic processing modules serving as the third components 93 and power supply modules serving as the second components 92; a plurality of graphics processing modules are provided, and accordingly a plurality of parallel portions are provided for the third segments 23; a cooling medium flowing out from the back panel 81 enters the third segments 23, where it is distributed and passes through respective graphics processing modules to undergo phase change and absorb heat, thereby becoming saturated vapor with a dryness fraction of approximately 1; subsequently, the cooling medium passes through the power supply modules, utilizes the convection of high-velocity vapor to absorb heat from the power supply modules, and then flows into the manifold 100 to be converged to the condenser of the condensing device 10, where it is re-condensed into liquid having a certain degree of subcooling.

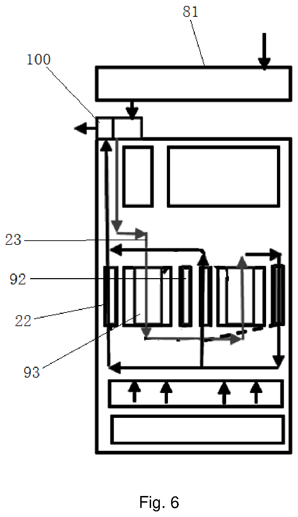

As shown in Fig. 6, the computing node is internally provided with central processing modules serving as the third components 93 and storage modules serving as the second components 92; a plurality of central processing modules are provided, and accordingly a plurality of parallel portions are provided for the third segments 23; a cooling medium flowing out from the back panel 81 enters the third segments 23, where it is distributed and passes through respective central processing modules to undergo phase change and absorb heat, thereby becoming saturated vapor with a dryness fraction of approximately 1; subsequently, the cooling medium passes through the storage modules, utilizes the convection of high-velocity vapor to absorb heat from the storage modules, and then flows into the manifold 100 to be converged to the condenser of the condensing device 10, where it is re-condensed into liquid having a certain degree of subcooling.

Generally speaking, the embodiments of the invention utilize the subcooled cooling liquid having a certain degree of subcooling from the condensing device as the cooling medium. The cooling liquid first absorbs heat discharged from low-power components inside the nodes by air cooling by means of the back panel. The saturated liquid refrigerant at the outlet of the back panel enters the manifold 100 inside the nodes, and then enters the nodes to cool components with high power dissipation. After the refrigerant becomes saturated vapor, it enters the components with medium power dissipation; after dissipating heat of the components with medium power dissipation by utilizing high-velocity flowing superheated vapor, the refrigerant re-enters the condensing device to be condensed into liquid refrigerant, and then enters the circulating pump, thus completing the cycle.

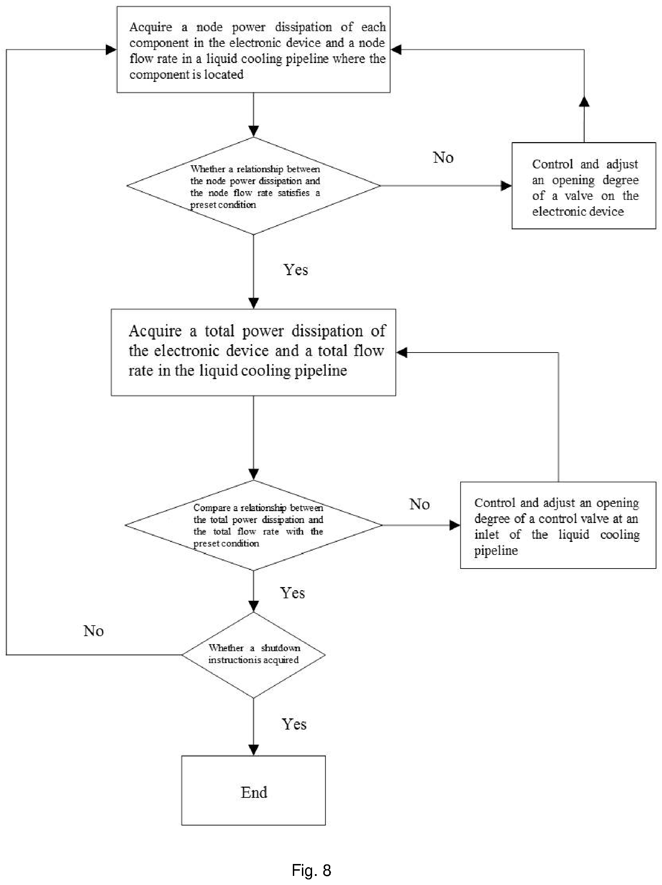

As shown in Fig. 8, the present embodiment further provides a liquid cooling control method for an electronic device, which is executed by using the foregoing electronic device. The liquid cooling control method for an electronic device includes: acquiring a node power dissipation of each component in the electronic device and a node flow rate in a liquid cooling pipeline 20 where the component is located; comparing a relationship between the node power dissipation and the node flow rate with a preset condition; and if the relationship does not satisfy the preset condition, controlling and adjusting an opening degree of a valve 50 on the electronic device until the relationship between the node power dissipation and the node flow rate satisfies the preset condition; acquiring a total power dissipation of the electronic device and a total flow rate in the liquid cooling pipeline 20; comparing a relationship between the total power dissipation and the total flow rate with the preset condition; and if the relationship does not satisfy the preset condition, controlling and adjusting an opening degree of a control valve 30 at an inlet of the liquid cooling pipeline 20 until the relationship between the total power dissipation and the total flow rate satisfies the preset condition. By means of the real-time acquisition and monitoring of power dissipation and flow rates of the component, the electronic nodes 90, and the electronic device as a whole, dynamic adjustment of flow distribution is achieved, thereby realizing the effect of matching flow rate with power dissipation, further avoiding the problem of flow drift, and improving the cooling effect.

In the present embodiment, the preset condition includes: the relationship between a flow rate and a power dissipation is as follows: power dissipation = degree of supercooling × mass flow rate × specific heat of liquid refrigerant + latent heat of vaporization × mass flow rate + degree of superheat × mass flow rate × specific heat of superheated vapor. The subcooling degree and superheat degree are preset values; the mass flow rate is acquired by the flow meter 40; and the latent heat of vaporization, the specific heat of the liquid refrigerant, and the specific heat of the superheated vapor are physical parameters. After acquiring the corresponding parameters, the control device 70 calculates, according to the foregoing relationship, whether the power dissipation and the flow rate meet the requirements, so as to adjust the flow rate, so that the power dissipation and the flow rate of each component and each of the plurality of electronic nodes 90 meet the requirements finally.

In the present embodiment, the liquid cooling control method for an electronic device further includes: when the preset condition is satisfied both between the node power dissipation and the node flow rate and between the total power dissipation and the total flow rate, acquiring a shutdown instruction; and when the shutdown instruction is not acquired, repeatedly acquiring the node power dissipation of each component in the electronic device and the node flow rate of the liquid cooling pipeline 20 where the component is located, and the process of acquiring the total power dissipation of the electronic device and the total flow rate of the liquid cooling pipeline 20. The described process is to achieve the objectives of real-time acquisition and monitoring, enabling the electronic device to maintain a real-time monitoring state of flow balance during operation, thereby ensuring that issues such as flow drift do not occur.

In the present embodiment, the liquid cooling control method for an electronic device further includes: acquiring an ambient temperature; and controlling the opening degree of the control valve 30 on a branch segment 212 of the liquid cooling pipeline 20 according to the ambient temperature, wherein the ambient temperature is directly proportional to the opening degree of the control valve 30 on the branch segment 212 of the liquid cooling pipeline 20. As described above, when the ambient temperature is too low in winter, the opening degree of the control valve 30 may be reduced or even closed to reduce the heat exchange of the back panel 81, thereby preventing the temperature inside the machine room from being too low. In summer, the control valve 30 may be fully opened to increase the heat exchange of the back plane 81, thereby preventing the temperature inside the machine room from being too high. This achieves a complementary and synergistic relationship between liquid-cooling heat dissipation and ambient heat dissipation, working together to achieve efficient cooling and heat dissipation for the electronic device.

It should be noted that, "a plurality of" in the foregoing embodiment refers to at least two.

From the description above, it can be seen that, in the liquid cooling system of an electronic device of the invention, an optimal design is performed on the fitting relationship between the first components 91, the second components 92 and the third components 93 and the liquid cooling pipeline 20, and the liquid cooling pipeline 20 passes through the first components 91, the third components 93, and the second components 92 in sequence, so that by fully utilizing the absorption potential of each phase during the gas-liquid two-phase state change of the cooling medium in the liquid cooling pipeline 20, and combining with the heat dissipation characteristics of each component, an optimal heat dissipation effect is achieved, thereby solving the problem of poor cooling effect of the two-phase liquid cooling system in the related art, and achieving the objective of greatly improving the cooling effect of the two-phase liquid cooling system. Furthermore, the electronic device of the invention may not only fundamentally solve the leakage risk of the current mainstream single-phase liquid cooling servers in the cabinet and the inadequacy in facing components with high heat density, but also completely eliminate the cavitation risk of the circulating pump faced by the two-phase liquid cooling servers in the cabinet, save 60% of the power dissipation of the circulating pump, improve the heat dissipation efficiency of the condenser end by 50%, reduce the volume and cost of the condensation heat exchanger of the condensing device by 50%, and also solve the problem of flow drift of parallel liquid cooling servers in the entire cabinet.

The liquid cooling system for an electronic device, the electronic device, and the liquid cooling control method for an electronic device provided in the invention are described in detail above. Specific examples have been applied herein to illustrate the principle and embodiments of the invention, and the description of the above embodiments is only used to help understand the method and core concept of the invention. It should be noted that for a person of ordinary skill in the present technical field, several improvements and modifications may also be made to the invention without departing from the principle of the invention, and these improvements and modifications shall fall within the scope of protection of the claims of the invention.

## Claims

1. A liquid cooling system for an electronic device, comprising:
a condensing device (10); and
a liquid cooling pipeline (20), wherein the liquid cooling pipeline (20) is in communication with the condensing device (10); a cooling medium in the liquid cooling pipeline (20) sequentially passes through first components (91), third components (93) and second components (92) of an electronic device, and returns to the condensing device (10); a heat-generating power dissipation of the third components (93) is greater than a heat-generating power dissipation of the first components (91) or a heat-generating power dissipation of the second components (92); and the cooling medium experiences a gas-liquid state change when passing through at least one component of the first components, the second components and the third components.

2. The liquid cooling system for an electronic device as claimed in claim 1, wherein the heat-generating power dissipation of the first components (91), the heat-generating power dissipation of the second components (92), and the heat-generating power dissipation of the third components (93) increase sequentially from low to high.

3. The liquid cooling system for an electronic device as claimed in claim 1, wherein a subcooled liquid medium in the condensing device (10) forms a saturated liquid medium in response to absorbing heat at the first components (91), the saturated liquid medium forms a saturated vapor medium in response to absorbing heat at the third components (93), the saturated vapor medium forms superheated vapor in response to absorbing heat at the second components (92), and the superheated vapor forms the subcooled liquid medium in response to being condensed in the condensing device (10).

4. The liquid cooling system for an electronic device as claimed in claim 3, wherein the subcooled liquid medium refers to the cooling medium being in a completely liquid state, having capacity to absorb heat before transitioning into a gaseous state; the saturated liquid medium refers to the cooling medium being in a liquid state, while simultaneously in a critical state between liquid and gaseous states; the saturated vapor medium refers to the cooling medium being in the gaseous state, and being in a critical state where it has completely transitioned from liquid to gas; and the superheated vapor refers to a state formed when the cooling medium continues to absorb heat on a basis of the saturated vapor medium.

5. The liquid cooling system for an electronic device as claimed in claim 1, wherein the liquid cooling pipeline (20) comprises a first segment (21), third segments (23) and second segments (22) that are in heat exchange cooperation with the first components (91), the third components (93) and the second components (92) respectively; and the first segment (21), the second segments (22), and the third segments (23) are located at a same electronic node (90) of the electronic device.

6. The liquid cooling system for an electronic device as claimed in claim 5, wherein the first segment (21) comprises a common segment (211) and a plurality of branch segments (212); each of the plurality of branch segments (212) is connected and in communication with the common segment (211); and the plurality of branch segments (212) are located in a heat dissipation region of the first components (91).

7. The liquid cooling system for an electronic device as claimed in claim 1, wherein the liquid cooling pipeline (20) comprises the first segment (21), the third segments (23) and the second segments (22) that are in heat exchange cooperation with the first components (91), the third components (93) and the second components (92) respectively; and at least one of the first segment (21), the second segments (22), and the third segments (23) is located at a different electronic node (90) of the electronic device.

8. The liquid cooling system for an electronic device as claimed in claim 7, wherein the first segment (21) comprises a common segment (211) and a plurality of branch segments (212); each of the plurality of branch segments (212) is connected and in communication with the common segment (211); and the plurality of branch segments (212) are located in a heat dissipation region of the first components (91).

9. The liquid cooling system for an electronic device as claimed in claim 8, wherein the liquid cooling system for an electronic device further comprises a control valve (30) configured to control a flow, the control valve (30) is disposed on the common segment (211) and/or at least one of the plurality of branch segments (212).

10. The liquid cooling system for an electronic device as claimed in claim 7, wherein there are a plurality of third components (93) which are grouped into a plurality of groups; third components (93) in different groups of the plurality of groups are arranged in layers and are arranged in the same or different electronic nodes (90); there are a plurality of third segments (23) which are connected and in communication with the first segment (21); and the plurality of third segments (23) are located at the third components in different groups respectively.

11. The liquid cooling system for an electronic device as claimed in claim 10, wherein there are a plurality of second components (92); the plurality of second components (92) are provided at layers where the third components in different groups are located; there are a plurality of second segments (22); the plurality of second segments (22) are located at second components (92) of different layers respectively, and are connected and in communication with the third segments (23) of a same layer.

12. The liquid cooling system for an electronic device as claimed in claim 10, wherein the liquid cooling system for an electronic device further comprises a flow meter (40) and a valve (50), the flow meter (40) and the valve (50) are provided at an inlet end of each of the second segments (22).

13. The liquid cooling system for an electronic device as claimed in claim 12, wherein the liquid cooling system for an electronic device further comprises an acquisition device (60) and a control device (70), the acquisition device (60) is electrically connected to the flow meter (40), and the control device (70) is electrically connected to the acquisition device (60) and the valve (50).

14. An electronic device, comprising:
a cabinet (80);
at least one electronic node (90), wherein the at least one electronic node (90) is provided in the cabinet (80), and each of the at least one electronic node (90) comprises first components (91), second components (92) and third components (93); and
the liquid cooling system for an electronic device as claimed in any one of claims 1 to 13, wherein a liquid cooling pipeline (20) penetrates between the cabinet (80) and the at least one electronic node (90).

15. The electronic device as claimed in claim 14, wherein the electronic device is a single-node device, and the liquid cooling pipeline (20) penetrates through an electronic node (90) of the single-node device and is sequentially in heat exchange cooperation with the first components (91), the third components (93), and the second components (92).

16. The electronic device as claimed in claim 14, wherein there are a plurality of electronic nodes (90); a first segment (21) of the liquid cooling pipeline (20) passes through a heat dissipation region of the first components (91) of each of the plurality of electronic nodes (90); and second segments (22) and third segments (23) of the liquid cooling pipeline (20) are provided in each of the plurality of electronic nodes (90).

17. The electronic device as claimed in claim 16, wherein the electronic device further comprises a manifold (100); the manifold (100) is provided between the first segment (21) and the third segments (23) and between the second segments (22) and a condensing device (10); a cooling medium of the first segment (21) is distributed to the third segments (23) by means of the manifold (100); and a cooling medium of the second segments (22) is converged to the condensing device (10) by means of the manifold (100).

18. The electronic device as claimed in claim 14, wherein each of the first components (91) comprises at least one of an input/output module and a hard disk module; each of the second components (92) comprises at least one of a power supply module and a storage module; and each of the third components (93) comprises at least one of a graphics processing module and a central processing module.

19. The electronic device as claimed in claim 14, wherein the electronic device comprises a first cooling apparatus (110); the first cooling apparatus (110) is provided at each of the first components (91); the first cooling apparatus (110) has a heat dissipation region; and a first segment (21) of the liquid cooling pipeline (20) absorbs heat of each of the first components (91) by means of the heat dissipation region.

20. The electronic device as claimed in claim 19, wherein the first cooling apparatus (110) is an air cooling device; the air cooling device is connected to the first components (91); and an air outlet of the air cooling device serves as the heat dissipation region.

21. The electronic device as claimed in claim 20, wherein the cabinet (80) is provided with a back panel (81); the air cooling device is provided inside the back panel (81); the heat dissipation region of the air cooling device faces the back panel (81); and the first segment (21) of the liquid cooling pipeline (20) is located at the back panel (81).

22. A liquid cooling control method for an electronic device, wherein the liquid cooling control method is executed using the electronic device as claimed in any one of claims 14 to 21, and the liquid cooling control method for an electronic device comprises:
acquiring a node power dissipation of each component in the electronic device and a node flow rate in a liquid cooling pipeline (20) where the component is located; comparing a relationship between the node power dissipation and the node flow rate with a preset condition; and if the relationship between the node power dissipation and the node flow rate does not satisfy the preset condition, controlling and adjusting an opening degree of a valve (50) on the electronic device until the relationship between the node power dissipation and the node flow rate satisfies the preset condition; and
acquiring a total power dissipation of the electronic device and a total flow rate in the liquid cooling pipeline (20); comparing a relationship between the total power dissipation and the total flow rate with the preset condition; and if the relationship between the total power dissipation and the total flow rate does not satisfy the preset condition, controlling and adjusting an opening degree of a control valve (30) at an inlet of the liquid cooling pipeline (20) until the relationship between the total power dissipation and the total flow rate satisfies the preset condition.

23. The liquid cooling control method for an electronic device as claimed in claim 22, wherein the preset condition comprises: a relationship between a flow rate and a power dissipation is as follows: power dissipation = degree of supercooling × mass flow rate × specific heat of liquid refrigerant + latent heat of vaporization × mass flow rate + degree of superheat × mass flow rate × specific heat of superheated vapor; wherein the degree of supercooling and the degree of superheat are preset values; the mass flow rate is acquired by a flow meter (40); and the latent heat of vaporization, the specific heat of the liquid refrigerant and the specific heat of superheated vapor are physical parameters.

24. The liquid cooling control method for an electronic device as claimed in claim 22, wherein the liquid cooling control method for an electronic device further comprises: when the preset condition is satisfied both between the node power dissipation and the node flow rate and between the total power dissipation and the total flow rate, acquiring a shutdown instruction; and when the shutdown instruction is not acquired, repeating a process of acquiring the node power dissipation of each component in the electronic device and the node flow rate of the liquid cooling pipeline (20) where the component is located, and a process of acquiring the total power dissipation of the electronic device and the total flow rate of the liquid cooling pipeline (20).

25. The liquid cooling control method for an electronic device as claimed in claim 22, wherein the liquid cooling control method for an electronic device further comprises: acquiring an ambient temperature; and controlling the opening degree of the control valve (30) on a branch segment (212) of the liquid cooling pipeline (20) as claimed in the ambient temperature, wherein the ambient temperature is directly proportional to the opening degree of the control valve (30) on the branch segment (212) of the liquid cooling pipeline (20).
